# EUROPEAN PATENT APPLICATION

(11) **EP 1 772 538 A1**
(43) Date of publication of application: **11.04.2007**
(21) Application number: 05022062.3
(22) Date of filing: 10.10.2005
(51) Int. Cl.: C30B 25/10, C30B 29/40

(54) **Process and apparatus for producing single crystal**

(71) Applicant: Crystal Systems Inc., Kitakoma-gun, Yamanashi (JP)
(72) Inventor: Shindo, Isamu, Yamanashi (JP); Koukitu, Akinori, Fuchu-shi Tokyo (JP)
(74) Representative: Kador & Partner

(57) **Abstract**

Disclosed are a production apparatus and a production process in which a thick and high-quality single crystal film can be formed on both sides of a colored substrate.

Both single crystal growth surfaces of a colored substrate which has been fixed through a substrate holder within a reactor are substantially evenly heated by at least one pair of infrared irradiation devices each comprising an infrared generating source and a reflecting mirror to produce a single crystal.

## Description

### FIELD OF THE INVENTION

The present invention relates to a process and apparatus for producing a single crystal. More particularly, the present invention relates to a process and apparatus for producing a high-quality single crystal which is suitable for use as a fundamental element of a semiconductor element used in a wide variety of equipment such as laser equipment and optical communication equipment.

### BACKGROUND OF THE INVENTION

Single crystals have hitherto been widely used as fundamental elements indispensable to semiconductor elements for use in a wide variety of equipment such as laser equipment and optical communication equipment, specifically as substrate wafers. In particular, for example, an HB (horizontal Bridgman) method and an LEC (liquid encapsulated Czochralski) method have been used as a production process of a single crystal of a compound semiconductor for use in optical elements to put compound semiconductors such as GaAs, InP, GaP, and InAs to practical use.

On the other hand, for nitride semiconductors comprising nitrogen (N) as a constituent element among compound semiconductors, the equilibrium vapor pressure of nitrogen at the melting point of the crystal is so high that a single crystal cannot be grown by the above HB and LEC methods without difficulties. To overcome the difficulties, various methods, for example, vapor deposition methods such as a chemical vapor deposition (hereinafter often referred to as "CVD method"), a sputtering method, and a molten salt method, have been proposed in the preparation of single crystals of nitride semiconductors, and some of them have been put to practical use.

For example, a metal organic vapor phase epitaxial growth method is known as one of chemical vapor deposition methods. According to this method, a highly reactive organic metal is used as a raw material, necessary organic metal vapor is introduced into a reactor, and a reaction is allowed to proceed at a predetermined temperature to grow a single crystal on a substrate. By virtue of this constitution, advantageously, a high-quality single crystal can easily be produced. The conventional method, however, suffers from a problem that the growth rate of the single crystal is low and is about several microns per hr.

Hydride vapor phase epitaxy (hereinafter abbreviated to "HVPE method") is also known as one of other chemical vapor deposition methods. This method has drawn attention as a method which is most suitable for practical use by virtue of a high film formation rate of several hundred microns per hr, and many achievements have been made.

For example, a gallium nitride thin film single crystal, which is a most promising blue laser oscillating element, is prepared by reacting a gallium metal heated to 750°C to 880°C with hydrogen chloride gas to give gallium chloride, introducing this gallium chloride together with ammonia gas into a reactor heated to a temperature around 1100°C, and allowing a gallium nitride single crystal to grow on a sapphire single crystal substrate.

In the production of a single crystal by chemical vapor deposition methods typified by the above means, since the raw material gas is allowed to react on a substrate to grow a single crystal, the substrate should be heated.

Conventional methods proposed for heating this substrate include the above method in which the whole reactor is externally heated, a method in which a heating source is provided at a position near the surface of the substrate opposite to the crystal growth surface and the substrate is heated directly by heat from the heating source, and a method in which the substrate is heated indirectly.

In the method in which the whole reaction chamber is heated, however, the reactor per se is also disadvantageously heated. Therefore, the reaction proceeds in the whole reactor, and, in many cases, selective growth of a thin film single crystal on a substrate has been difficult. Further, due to the restriction of the softening temperature of quartz (about 1200°C) commonly used as the reactor vessel, the growth of the single crystal at a temperature at or above this temperature has been difficult.
(i) A method in which a resistance heating type heater is provided on the lower side of the substrate to heat the substrate is known as the method in which the substrate is heated directly by a heating source. Examples of the methods proposed for heating the substrate indirectly include (ii) a method in which a highly electrically conducting material called a susceptor is disposed on the lower side of the substrate and is heated by a high frequency dielectric heating method from the outside of the reactor to maintain the substrate temperature at a predetermined temperature and (iii) a method in which a plate formed of a material capable of absorbing infrared light, such as graphite, is placed on the lower side of the substrate and infrared light is externally applied to this plate to heat the plate which then heats substrate indirectly.

In the method (i) in which a resistance heating type heater is used, however, for example, a raw material gas comprising an organometal gas, hydrogen chloride gas and the like or an exhaust gas after the completion of the reaction is in some cases very highly reactive and is highly corrosive, often making it difficult to stably use the heater for a long period of time due to the corrosion of the heater.

Further, in the method (ii) in which the substrate is heated by the high frequency dielectric heating method and the method (iii) in which a plate formed of a material capable of absorbing infrared light such as graphite (hereinafter referred to as "substrate plate") is placed on the lower side of the substrate to heat the substrate indirectly, the susceptor or the substrate plate becomes the highest temperature and, in addition, the temperature of a part around the susceptor and the substrate plate is also raised, thus, disadvantageously, the reaction also takes place on the periphery of the substrate around the substrate plate. Accordingly, the expensive raw material gas is wastefully consumed, and these methods cannot solve the problem that stable growth of a single crystal on the substrate is inhibited. Further, it should noted that, in all the methods (i), (ii) and (iii), one side of the substrate is heated, and a single crystal growth reaction proceeds on the opposite surface. Therefore, bending or the like attributable to a difference in coefficient of thermal expansion and a difference in lattice constant between the sapphire single crystal as the substrate and the single crystal grown on the substrate increases with increasing the thickness of the grown single crystal. This makes it difficult to lower the temperature after the completion of the growth reaction for isolating the substrate and the single crystal from each other, and, thus, in some cases, renders the occurrence of cracks and the like during the isolation work unavoidable.

On the other hand; to solve these problems, a process for producing a thin film single crystal has been proposed in which one side of a colored substrate is irradiated with infrared light to allow a single crystal to grown on the substrate (see, for example, Japanese Patent Laid-Open No. 53495/2000). This process is superior to the conventional methods (i) to (iii) in that, since the substrate on which a single crystal is grown is heated directly, the amount of the raw material gas used can be significantly reduced and, in addition, the reaction around the substrate can also be significantly reduced. This process, however, is disadvantageous in that, due to bending after the growth of the single crystal, simple cutting work cannot be applied without difficulties in the process of isolating the thin film single crystal from the substrate and, thus, the isolation should be carried out by a special method such as laser beam irradiation. In the cutting process, in some cases, cracking or the like disadvantageously takes place, and, thus, there is still a problem to be solved for stably producing a high-quality thick single crystal film.

### DISCLOSURE OF THE INVENTION

Accordingly, an object of the present invention is to provide a process for producing a single crystal by chemical vapor deposition, which can produce a high-quality thick single crystal film without wasteful consumption of a raw material gas while suppressing bending and the like.

Another object of the present invention is to provide an apparatus for use in the production process.

The present inventors have made extensive and intensive studies with a view to solving the above problems of the prior art and as a result have found that, when a production process of a single crystal comprising producing a single crystal on a colored substrate by chemical vapor deposition and characterized by focusing infrared light with a reflecting mirror to directly heat both sides of the colored substrate is used, only the crystal growth surface on the substrate can be heated and maintained at a desired temperature and, in addition, temperature conditions for providing a very homogeneous temperature with a very small temperature distribution can be realized on the substrate and that, thus, the raw material gas can be efficiently used and a high-quality single crystal in which the level of defect is very small can be produced with high efficiency. The present inventors have further found that a single crystal can be efficiently produced by allowing the single crystal to grow on both sides of the substrate, and, at the same time, the occurrence of bending attributable to a difference in coefficient of thermal expansion during cooling can be reduced and the substrate and the grown high-quality single crystal can be easily isolated from each other by simple cutting. The above finding has led to the completion of the present invention.

Thus, according to one aspect of the present invention, there is provided a process for producing a single crystal by chemical vapor deposition on a substrate, wherein said substrate is a colored substrate having an infrared absorbing capacity, infrared light, which has been focused by a reflecting mirror, is applied to both sides of the substrate to heat said substrate, and a raw material gas is allowed to react on the surface of said substrate to grow a single crystal on both sides of said substrate.

In this case, preferably, said colored substrate is a colored corundum single crystal plate, said reflecting mirror is an elliptical mirror, and said infrared light is generated from a halogen lamp as an infrared generating source.

In the production process of a single crystal according to the present invention, only the colored substrate can be heated by selectively absorbing infrared light in the substrate without transmission of the infrared light through the substrate. Therefore, a nitride semiconductor single crystal can be suitably produced by using a metal chloride and ammonia as the raw material gas.

According to another aspect of the present invention, there is provided an apparatus for producing a single crystal on both sides of a colored substrate, said apparatus comprising a reactor and at least a pair of infrared irradiation devices each comprising an infrared generating source and a reflecting mirror, wherein said colored substrate is fixed through a substrate holder within said reactor, said reactor comprises a raw material gas introduction tube, a waste gas discharge tube, and an infrared transparent window, said at least one pair of infrared irradiation devices are disposed outside said reactor so as to face each other, and both sides of said colored substrate on which said single crystal is grown are substantially evenly heated by said infrared irradiation devices through said infrared transparent window.

In the apparatus for producing a single crystal preferably, said colored substrate is fixed so that the single crystal growth surfaces on said colored substrate are substantially vertical.

In the production process of a single crystal according to the present invention, only the colored substrate can be selectively heated, and, further, the temperature control can also be easily carried out. Therefore, a single crystal can be produced with a significantly high efficiency. Furthermore, a single crystal, which has uniform thickness and is free from a significant level of bending, can be produced simultaneously on both sides of the substrate so as to sandwich the substrate therebetween. At the same time, a thick bulk single crystal can also be easily produced.

### BRIEF DESCRIPTION OF THE DRAWING

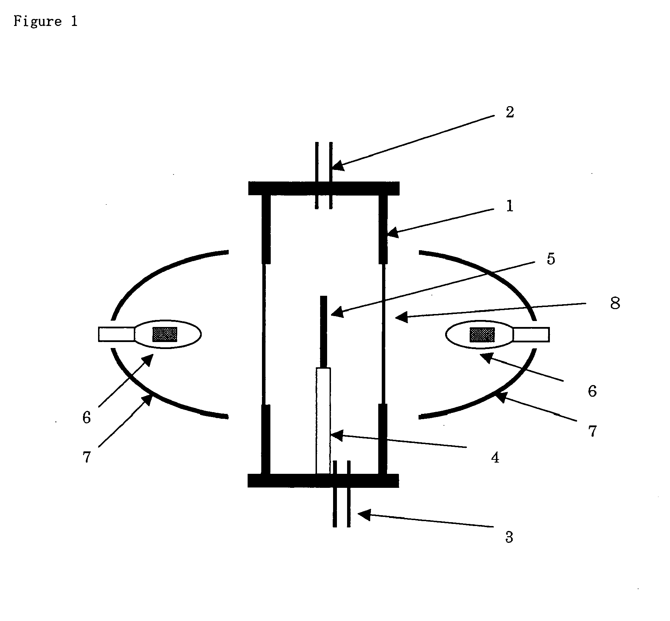

Fig. 1 is a schematic diagram showing an embodiment of the apparatus according to the present invention.

In the drawing,
1: reactor,
2: raw material gas introduction tube,
3: exhaust gas discharge tube,
4: substrate holder,
5: colored substrate,
6: infrared generating source,
7: reflecting mirror, and
8: infrared transparent window.

### DETAILED DESCRIPTION OF THE INVENTION

The present invention will be described in more detail.

The production process of a single crystal according to the present invention is substantially characterized in that infrared light focused by a reflecting mirror such as an elliptical mirror is applied onto both crystal growth surfaces of a colored substrate capable of absorbing infrared light to selectively heat the colored substrate to a predetermined temperature and to maintain the temperature, and, in this state, a single crystal is produced by chemical vapor deposition.

### [Colored substrate]

In the present invention, since the substrate should be selectively heated, the substrate should be a colored substrate capable of absorbing infrared light. The colored substrate is not particularly limited so far as infrared light can be absorbed therein. For example, a single crystal formed by using a coloring agent and an inorganic oxide as raw materials can be used as the colored substrate. When this single crystal is used as the colored substrate, a desired single crystal can easily be produced.

Inorganic oxides usable as the raw material of the single crystal include, for example, oxides and composite oxides such as alumina (Al₂O₃), rutile (TiO₂), strontium titanate (SrTiO₃) , and spinel (Al₂O₃ + MgO). When these inorganic oxides are used as one of the raw materials of the single crystal, various infrared absorbing materials which can color these inorganic oxides can be used as the coloring agent.

For example, when alumina (aluminum oxide: Al₂O₃) is used as the inorganic oxide, the coloring agent may be chromium oxide, iron oxide, and titanium oxide or the like.

When a combination of aluminum oxide with chromium oxide or titanium oxide is used, ruby can be obtained as the single crystal. On the other hand, when a combination of aluminum oxide, iron oxide, and titanium oxide is used, blue sapphire can be obtained as the single crystal.

Single crystals of semiconductors such as silicon single crystals or gallium arsenide single crystals may also be used as the single crystal used as the colored substrate.

These single crystals may be prepared, for example, by the following methods:
(1) flame fusion method (Vernuil method),
(2) crystal pulling method (Czochralski method),
(3) EFG method (edge defined film growth method),
(4) Bridgeman method or pull down method, and
(5) Kyropoulus method.

In the method (1), hydrogen gas is burned in oxygen gas, and a raw material powder is dropped little by little from above the flame to melt the powder, and the melt is then solidified at the bottom to prepare a single crystal.

In the method (2), a raw material powder is heated in an iridium or molybdenum crucible to melt the raw material, a seed crystal is immersed in the melt, and the seed crystal is pulled up while growing around the seed crystal to prepare a single crystal.

In the method (3), as with the method (2), in a crucible, a raw material is melted, a plate is floated on the surface of a melt while providing a space, and a melt is allowed to exude through the space to prepare a single crystal in a shape which conforms to the space. When the form of the space is a straight line, a plate-shaped single crystal can be prepared, while, when the form of the space is cylindrical, a pipe-shaped single crystal can be prepared.

The Bridgeman method as the method (4) is a method known also as a pull down method. In this method, a single crystal seed is placed in the bottom of a crucible, with care so as to avoid the melting of the whole seed, the raw material powder is melted, and the crucible is then pulled down to allow growing to slowly proceed around the seed crystal remaining unmelted while solidification to prepare a single crystal.

Further, in the method (5) called the Kyropoulus method, as with the crystal pulling method, the raw material is melted in a crucible, a seed crystal is dipped in the melt, and solidification is slowly carried out in a direction from the top to the bottom. Principally, this method is the same as the pulling method. However, in the ordinary pulling method, while rotating the grown crystal, the grown crystal is pulled upward, whereas, in the Kyropoulus method, solidification is slowly carried out wihtout rotation.

The method for preparation of the single crystal is not particularly limited. Preferably, however, the method selected can provide a high-quality single crsytal. This is because, when the single crystal in the substrate has high quality, a high-quality single crystal can be grown on the substrate.

The flame fusion method as the method (1) is the lowest-production cost method and is widely used in industry. In this method, however, the growth of the high-quality of single crystal is generally difficult. On the other hand, single crystals prepared in the methods (2) to (5) generally have high quality, and, thus, the single crystals prepared in the methods (2) to (5) are suitable for use in the present invention.

The single crystal thus obtained is then subjected to fabrication such as cutting or polishing to prepare a colored substrate having a desired shape.

The optimal material can be selected as the material used in the colored substrate according to the type of a thin-film single crystal grown on the colored substrate.

For example, when the thin-film single crystal used as a nitride semiconductor such as gallium nitride or aluminum nitride is grown on the colored substrate, colored corundum single crystals may be suitably used as the colored substrate. Among the colored corundum single crystals, ruby may be particularly suitably used.

The reason why ruby is particularly suitable is as follows. Specifically, since ruby has hitherto been utilized in a large quantity in bearings for clocks, the step of fabrication such as cutting or polishing is established. Further, due to properties of the incorporated coloring agent, mechanical properties of ruby are better than those of sapphire, and, thus, warpage and the like are less likely to occur during fabrication. Since working properties and the like are excellent, high-quality substrates can be produced in a good yield.

The color of the colored substrate is not particularly limited so far as the colored substrate can absorb infrared light. When the color of the colored substrate is selected, the selection can be carried out by using a technique such as a method for coloring an artificial jewel with an additive. For example, in the case of the above ruby, red is a basic color.

The method using the colored substrate is essentially different from the conventional method in which graphite is used as a base plate which is heated to indirectly heat the substrate. In the method using the base plate, the base plate part is a part where, in the reaction system, the temperature becomes the highest and the reaction is most vigorous. Therefore, the expensive raw material gas is wastefully consumed, and, at the same time, the fine particles of the single crystal formed on the base plate part is disadvantageously deposited onto the substrate, resulting in deteriorated properties of the single crystal. On the other hand, in the method according to the present invention, since the colored substrate is selectively directly heated, the highest temperature part in the reaction system is the crystal growth face part in the substrate. Therefore, the reaction at the place other than the substrate can be suppressed, and the raw material gas is not wastefully consumed. Further, the place where the single crystal is grown can be limited to the top of the substrate. Therefore, any problem such as the adhesion of the fine particle of single crystal does not occur, and a high-quality single crystal can be very easily grown.

### [Infrared light generating source]

According to the production process of a single crystal according to the present invention, infrared light focused on a reflecting mirror is used for heating the colored substrate. The infrared light generating source is not particularly limited so far as infrared light can be generated, and examples thereof include xenon lamps and halogen lamps. Among them, halogen lamps are preferred. The halogen lamps are inexpensive and have stable output, and, thus, the substrate temperature can be evenly and stably maintained.

The method in which infrared light emitted from the infrared light source is focused on a reflecting mirror and the focused light is applied onto the colored substrate is not particularly limited so far as the reflecting mirror is used. Preferably, however, from the viewpoint of efficiently heating the crystal growth face on the substrate surface to a desired temperature and further maintaining the temperature under highly uniform conditions, infrared light emitted from a halogen lamp or the like is focused with an elliptical mirror and the focused light is applied. The method in which heating is carried out from one side of the substrate is also possible. In this case, however, as compared with the method in which heating is carried out from both sides of the substrate, the thickness of the single crystal is likely to be nonuniform, disadvantageously often leading to a high possibility of occurrence of bending after cooling. Further, in the present invention, a pair of infrared irradiation devices each comprising an infrared light generating source and a reflecting mirror, that is, two infrared irradiation devices, may be used for heating both sides of the substrate. Furthermore, a method may also be adopted in which two or more pairs, that is, a plurality of pairs, of infrared irradiation devices (2n infrared irradiation devices wherein n is an integer of 2 or more) are used for heating the substrate.

### [Production process of single crystal]

In the production process of a single crystal according to the present invention, both sides of the colored substrate are directly irradiated with infrared light for heating. The temperature of the top of the substrate can be easily raised to a temperature best suited for the growth of a single crystal, by infrared, heating both sides of the substrate. For example, when a gallium nitride single crystal is grown by hydride vapor phase epitaxy, a high-quality gallium nitride single crystal having no significant defect density can be produced by directly heating both sides of the substrate to a substrate temperature of 1200°C or above. Further, according to the above production process, only the substrate installed within the reactor can easily be maintained at a predetermined crystal growth temperature while maintaining the temperature of the other part at a temperature below the crystal growth temperature. Therefore, a crystal growth reaction of the introduced raw material gas can be allowed to proceed only on the substrate while the side reaction at the other part can be suppressed on a very low level. Therefore, in the production process of a single crystal according to the present invention, a single crystal can be stably produced for a long period of time, and the production of a single crystal film having a thickness of not less than 10 mm is also possible.

Further, since the crystallization rate on both sides of the substrate can be regulated at a given rate, the crystal can be grown on both sides of the substrate with a homogeneous thickness increase. Therefore, the occurrence of bending caused by strain between the substrate and the single crystal can be reduced to a very low level. This facilitates cutting of the single crystal into a predetermined thin plate and can realize stable mass production of a high-quality single crystal.

High-quality single crystal thus obtained include, for example, gallium nitride single crystals, aluminum nitride single crystals, and nitride semiconductor single crystals such as mixed crystals comprising these compounds at any desired composition ratio. Among these crystals, a part of aluminum and gallium contained in the crystal may be replaced by boron, thallium or the like, or alternatively a part of nitrogen contained in the above crystal may be replaced by phosphorus, arsenic, antimony, bismuth or the like.

The raw material gas for producing a single crystal is not particularly limited so far as it can be used in chemical vapor deposition, particularly in thermal CVD.

For example, in the production of the nitride semiconductor single crystal, metal chlorides such as gallium chloride and aluminum chloride and ammonia gas may be used as the raw material.

The metal chloride can be produced by heating a metal such as gallium and reacting this with hydrogen chloride.

Any carrier gas commonly used in thermal CDV may be used as the carrier gas, and examples thereof include hydrogen gas and nitrogen gas.

The reaction temperature can be regulated by controlling the quantity of energy of the infrared generating source, for example, electric power supplied to the halogen lamp. Specifically, a method may be adopted in which an electric power regulator is connected to a halogen lamp and the output of the electric power regulator is regulated by external signals to conduct remote control, automatic control or the like.

The crystal growth reaction is preferably carried out within a reactor in which the colored substrate is disposed, from the viewpoints of suppression of side reactions, easiness on the control of the atmosphere, stability of the reaction and the like. Further, the production process of a single crystal according to the present invention may be carried out by further adding a preferred other technique commonly used in chemical vapor deposition.

### [Single crystal production apparatus]

The thin film single crystal production apparatus according to the present invention is a single crystal production apparatus for producing a single crystal on both sides of a colored substrate, said apparatus comprising a reactor and at least one pair of infrared irradiation device comprising an infrared light generating source and a reflecting mirror.

### (a) Reactor

The reactor constituting the single crystal production apparatus according to the present invention comprises a raw material gas introduction tube, an exhaust gas discharge tube, and an infrared transparent window.

The material of the reactor is not particularly limited so far as the above single crystal can be produced, and examples thereof include stainless steel, transparent alumina, quartz, and heat resistant glass.

The material of the infrared transparent window provided in the reactor is not particularly limited so far as the material is transparent to infrared light, and examples thereof include transparent alumina, quartz, and heat resistant glass. When quartz or heat resistant glass is used as the reactor, the principal part or the whole of the reactor may of course be formed of quartz or heat resistant glass. For example, a pipe material formed of quartz or heat resistant glass may be used as a raw material for the manufacture of a tubular reactor.

An introduction tube for introducing a raw material gas and an exhaust tube for discharging waste gas are connected to the reactor according to the present invention. Positions where the introduction tube and the exhaust pipe are disposed are not particularly limited so far as the introduction pipe and the exhaust pipe are installed.

### (b) Substrate holder

A substrate holder is disposed within the reactor constituting the single crystal production apparatus according to the present invention. This substrate holder is not particularly limited so far as the colored substrate used in the production process of a single crystal can be fixed without breaking.

### (c) Infrared irradiation device

The infrared irradiation device constituting the single crystal production apparatus according to the present invention is at least one pair of infrared irradiation devices that each comprise an infrared light generating source and a reflecting mirror and are disposed outside the reactor so as to face each other.

For the infrared light generating source and the reflecting mirror, those usable in the above single crystal production process may be suitably used. Accordingly, the infrared light generating source is particularly preferably a halogen lamp, and the reflecting mirror is particularly preferably an elliptical mirror.

Both sides of the single crystal growth face on the colored substrate can be substantially evenly heated through the infrared transparent window by this infrared irradiation device.

The single crystal production apparatus according to the present invention having the above construction is suitable for carrying out the production process of a single crystal according to the present invention.

In the production apparatus according to the present invention, preferably, the colored substrate is disposed within the reactor through the substrate holder so that the crystal face of the colored substrate is substantially vertical. The provision of the colored substrate in this way is advantageous in that the difference in gas flow between both sides of the substrate can be reduced to evenly grow a single crystal.

### EXAMPLES

The present invention will be described in more detail with reference to the following examples. However, it should be noted that the present invention is not limited to these examples only.

### Example 1

### <Single crystal production apparatus>

For example, an apparatus exemplified in Fig. 1 may be mentioned as an embodiment of a single crystal production apparatus for use in the production process of the present invention.

In this apparatus for producing a thin-film single crystal, a reactor (1), which is provided with a raw material gas introducing tube (2) and a discharge tube (3) for discharging a waste gas and has an infrared transparent window (8), is provided. A colored substrate (5) is fixed substantially vertically through a substrate holder (4) within the reactor (1). A set of infrared irradiation devices each comprised of an infrared generating source (6) and a reflecting mirror (7) are disposed outside the reactor (1).

A transparent quartz plate is used as a window material in the reactor (1), and a single crystal plate of ruby as the colored substrate (5). The infrared generating source (6) is a halogen lamp. An elliptical mirror is used in the reflecting mirror (7). When the reflecting mirror (7) is used in one set of infrared irradiation devices each comprised of the infrared generating source (6) and the reflecting mirror (7), a set of reflecting mirrors (7) constitute an elliptical mirror (a double-elliptical mirror). Infrared light emitted from the infrared generating source (6) is focused on the reflecting mirror (7), and the focused light heats the colored substrate (5) to selectively heat the colored substrate (5) and thus to maintain the temperature of the colored substrate (5) on its surface at a predetermined temperature. In this case, since the colored substrate is heated from both sides thereof, thin film formation proceeds on both sides of the colored substrate.

### <Production of gallium nitride single crystal>

Actually, a gallium nitride single crystal was produced using the apparatus shown in Fig. 1. In this case, in the apparatus shown in Fig. 1, a transparent quartz plate was used as the infrared transparent window material, a ruby single crystal (red) composed of A1₂O₃ doped with 0.3% of Cr₂O₃ was used as the colored substrate (5), a halogen lamp was used as the heating source (6), and an elliptical mirror was used as the reflecting mirror (7).

At the outset, metallic gallium was heated to 750 to 880°C within a separately provided reactor. A mixed gas composed of hydrogen chloride gas and hydrogen gas was sprayed against the metallic gallium to produce gallium chloride. The gallium chloride thus produced and ammonia gas, together with hydrogen gas as carrier gas, are introduced through the raw material gas introducing tube (2) into the reactor (1). The ruby single crystal plate was heated by infrared light which had been emitted from the halogen lamp and focused by the elliptical mirror to 1200°C, and, while maintaining the temperature of the ruby single crystal plate at that temperature, a single crystal of gallium nitride was grown on both sides of the ruby single crystal plate. As a result, a good-quality bulk single crystal having a large thickness of more than 5 mm, which had hitherto been regarded as being unattainable, could be produced.

Further, the production process of a single crystal according to the present invention could realize heating of the substrate only, and, in addition, the single crystal could be simultaneously formed on each flat surface on both sides of the substrate. This resulted in an about fivefold improvement in reaction efficiency over the conventional production process (alumina substrate which is different from the ruby single crystal substrate).

The simultaneous formation of a thick-film single crystal on both sides of the substrate could prevent bending even after taking the substrate out of the reactor and could realize the production of a very high-quality single crystal with good efficiency. Further, these single crystals could easily be cut by simple cutting work without causing cracking.

### Example 2

### <Production of aluminum nitride single crystal>

An aluminum nitride single crystal was produced using the single crystal production apparatus used in Example 1.

At the outset, aluminum trichloride was filled into a separately provided thermostatic vessel. This vessel was then maintained at a constant temperature of 100 to 150°C, and hydrogen gas was passed through the vessel to introduce aluminum trichloride vapor corresponding to the temperature through the raw material gas introducing tube (2) into the reactor (1). Likewise, ammonia gas, together with hydrogen gas as carrier gas, was introduced through the raw material gas introducing tube (2) into the reactor (1). The ruby single crystal plate was heated to 1350°C by infrared light which had been emitted from the halogen lamp and focused by the elliptical mirror, and, while maintaining the temperature of the ruby single crystal plate at that temperature, a single crystal of gallium nitride was grown on both sides of the ruby single crystal plate. As a result, a good-quality bulk single crystal of aluminum nitride having a large thickness of more than 7 mm, which had hitherto been regarded as being unattainable, could be produced.

Further, the production process of a single crystal according to the present invention could realize heating of the substrate only and thus could realize growth of the single crystal at a temperature at or above the softening point of the reaction vessel (quartz).

Further, since the high temperature 1350°C was used, the defect density, which is said to be attributable to a difference in lattice constant between the substrate crystal and the single crystal, decreased with increasing the thickness of the grown film, and the defect density, which is said to be generally not less than 10¹²/cm³, was reduced to not more than 10⁷/cm³. The simultaneous formation of a thick-film single crystal on both sides of the substrate could prevent bending even after taking the substrate out of the reactor. Further, these single crystals could easily be cut by simple cutting work without causing cracking.

## Claims

1. A process for producing a single crystal by chemical vapor deposition on a substrate, wherein
said substrate is a colored substrate having an infrared absorbing capacity,
infrared light, which has been focused by a reflecting mirror, is applied to both sides of the substrate to heat said substrate, and
a raw material gas is allowed to react on the surface of said substrate to grow a single crystal on both sides of said substrate.

2. The process for producing a single crystal according to claim 1, wherein said colored substrate is a colored corundum single crystal plate, said reflecting mirror is an elliptical mirror, and said infrared light is generated from a halogen lamp as an infrared generating source.

3. The process for producing a single crystal according to claim 1 or 2, wherein said raw material gas comprises a metal chloride and ammonia for producing a nitride semiconductor single crystal.

4. An apparatus for producing a single crystal on both sides of a colored substrate, said apparatus comprising a reactor and at least a pair of infrared irradiation devices each comprising an infrared generating source and a reflecting mirror, wherein
said colored substrate is fixed through a substrate holder within said reactor,
said reactor comprises a raw material gas introduction tube, a waste gas discharge tube, and an infrared transparent window,
said at least one pair of infrared irradiation devices are disposed outside said reactor so as to face each other, and
both sides of said colored substrate on which said single crystal is grown are substantially evenly heated by said infrared irradiation devices through said infrared transparent window.

5. The apparatus for producing a single crystal according to claim 4, wherein said colored substrate is fixed so that the single crystal growth surfaces on said colored substrate are substantially vertical.
